Europäisches Patentamt

European Patent Office

Office européen des brevets

(11) Veröffentlichungsnummer: **0 503 337 A2**

# EUROPÄISCHE PATENTANMELDUNG

(21) Anmeldenummer: **92103003.7**

(22) Anmeldetag: **22.02.92**

(51) Int. Cl.5: **G11C 11/419**

(30) Priorität: **08.03.91 DE 4107420**

(43) Veröffentlichungstag der Anmeldung:
**16.09.92 Patentblatt 92/38**

(84) Benannte Vertragsstaaten:
**AT CH FR GB IT LI**

(71) Anmelder: **MIKROELEKTRONIK UND TECHNOLOGIE GESELLSCHAFT mbH**

Grenzstrasse 28
O-8080 Dresden(DE)

(72) Erfinder: **Schniek, Horst-Günter, Dipl.-Phys.**
**Hennersdorfer Weg 16**
**O-8027 Dresden(DE)**
Erfinder: **Griesbach, Horst, Dipl.-Ing.**
**Dörnichtweg 37**
**O-8080 Dresden(DE)**

(54) Schreib-Lese-Schaltung für einen statischen RAM.

(57) Die Erfindung löst die Aufgabe, eine Schreib-Lese-Schaltung für statische RAM zu entwickeln, welche bei hoher Lesegeschwindigkeit gleichzeitig eine große Störsicherheit in den Lesezyklen erreicht. Zur Anwendung kommt eine Schreib-Lese-Schaltung für einen statischen RAM mit n Bitleitungspaaren (BLi; /BLi; mit i = $\emptyset$...n) und m Wortleitungen (WL$\emptyset$...WLm), bei welcher die Bitleitungspaare (BLi; /BLi) jeweils mit den Knoten (Ki; /Ki) von Sensorflipflops (5.i) verbunden sind, deren Fußpunkttransistoren (8.i) von einem zugehörigen Latchtakt (LTk) gesteuert sind. Die Knoten (Ki; /Ki) sind über Auswahltransistoren (9.i; 9.i') mit Datenleitungspaaren (DLk; /DLk) des RAM verbunden. Die Auswahltransistoren (9.i; 9.i') sind von den einzelnen Bitleitungspaaren (BLi; /BLi) zugeordneten Ausgängen (BDi) eines Spaltendekoders (3) angesteuert. Erfindungsgemäß ist jeweils zwischen wahrer (BLi) bzw. negierter Bitleitung (/BLi) jedes Bitleitungspaares (BLi; /BLi) und wahrem (Ki) bzw. negiertem Knoten (/Ki) des zugehörigen Sensorflipflops (5.i) eine in ihrer Leitfähigkeit steuerbare Verbindung (4.i), welche beim Beschreiben des RAM durchgängig sowie beim Lesen zu Beginn des zugehörigen Latchtaktes (LTk) leitfähig ist und ihre Leitfähigkeit in dem Maße verliert, wie das Potential des Latchtaktes (LTk) steigt, angeordnet.

Die Erfindung wird in statischen RAM zur weiteren Beschleunigung des Datenzugriffes beim Lesen eingesetzt.

FIG. 1

EP 0 503 337 A2

Die Erfindung betrifft eine Schreib-Lese-Schaltung für statische RAM nach dem Oberbegriff des Patentanspruches 1 und wird in solchen Speichern zur weiteren Beschleunigung des Datenzugriffes beim Lesen eingesetzt.

Für Schreib-Lese-Speicher (RAM) sind unterschiedliche Schaltungen zum Schreiben und Lesen der Daten in bzw. aus Speicherzellen gebräuchlich. So sind Lösungen bekannt, bei denen das über Auswahltransistoren ausgewählte Bitleitungspaar direkt an ein zugehöriges Datenleitungspaar angeschlossen ist und somit die Speicherzellen einen an der Datenleitung angeschlossenen Leseverstärker direkt treiben. Eine entsprechende Schaltung, welche pMOS-Auswahltransistoren verwendet, ist in der EP-Anm. 257 912 dargelegt. Die Kapazität der Bitleitungen begrenzt dabei die Lesegeschwindigkeit beträchtlich.

In der EP-Anm. 121 208 ist eine Schreib-Lese-Schaltung für einen statischen RAM beschrieben, bei der in jeder Bitleitung ein gelatchtes Sensorflipflop angeordnet ist. Die Sensorflipflops bestehen jeweils aus zwei kreuzgekoppelten Transistoren mit gemeinsamem Fußpunkttransistor. In der beschriebenen Schaltung werden nMOS-Transistoren verwendet. An das Gate jedes Fußpunkttransistors ist ein aus den im Speicher geführten Steuersignalen abgeleiteter Latchtakt und an die Gates der Auswahltransistoren ein der entsprechenden Bitleitung zugeordneter Ausgang eines Spaltendekoders gelegt.

Nachteilig erscheint hier, daß der Einfluß der Bitleitungskapazitäten beim Lesen nicht unterdrückt wird, welche das Latchen der Sensorflipflops verzögern, und daß an die Sensorflipflops und die Auswahltransistoren verschiedene Takte zu führen sind.

Um den die Lesegeschwindigkeit herabsetzenden Einfluß der Bitleitungskapazitäten zu verringern, ist in der Schaltung nach EP-Anm. 230 385 ein auf das Potential der Betriebsspannung geklemmter nMOS-Barrieretransistor bzw. In der Schaltung nach DE-OS 38 26 218 ein auf Massepotential geklemmter pMOS-Barrieretransistor jeweils zwischen den Bitleitungen und den zugehörigen Knoten der Sensorflipflops geschaltet. Die beiden genannten Schaltungen sind zum Einsatz in dynamischen RAM konzipiert. Durch ihren Restwiderstand verringern dabei die Barrieretransistoren den Einfluß der Bitleitungskapazitäten beim Latchen der Sensorflipflops.

Aufgrund ihres im Lesezyklus konstanten Restwiderstandes können jedoch die Bitleitungskapazitäten zu Beginn des Anlatchens der Sensorflipflops nicht in vollem Maße zur Erhöhung der Störsicherheit benutzt werden.

Eine Anwendung der für die Bitleitungen beschriebenen Lösungen auf Datenleitungen ist nicht bekannt.

Desweiteren ist in der DE-OS 31 38 549 eine Schaltungsanordnung zur Ankopplung der Sensorflipflops an die Bitleitungen in einem dRAM beschrieben, bei der zur Reduzierung der Zugriffszeit beim Lesen des Speichers die Entladezeit der Bitleitungen verringert wird, indem parallel zu den Kopplungstransistoren zwischen den Bitleitungen und den Knoten der Sensorflipflops Transistoren geschaltet werden, die beim Lesen während der Informationsbewertung hochohmig und ansonsten niederohmig geschaltet sind. Damit können die Bitleitungen nach erfolgter Informationsbewertung über die zusätzlichen Transistoren schnell entladen werden. Zur Ansteuerung der zusätzlichen Transistoren wird ein gesondertes Taktsignal verwendet.

Der Erfindung liegt die Aufgabe zugrunde, eine Schreib-Lese-Schaltung für statische RAM zu entwickeln, welche bei hoher Lesegeschwindigkeit gleichzeitig eine große Störsicherheit in den Lesezyklen erreicht, wobei die erfindungsgemäße Schaltungsanordnung nur wenige Takte benötigen soll.

Erfindungsgemäß wird diese Aufgabe durch eine Schreib-Lese-Schaltung für einen statischen RAM mit den Merkmalen des Patentanspruches 1 gelöst.

Da die steuerbaren Verbindungen beim Lesen zu Beginn jedes Latchtaktes leitfähig sind, liegen zu Beginn des Latchens die Kapazitäten der Bitleitungen voll an den Knoten der zugehörigen Sensorflipflops an und unterstützen das Anlatchen, indem Unsymmetrien der Layoutgestaltung und weitere Störeinflüsse ausgeglichen werden.

Mit steigendem Potential des Latchtaktes werden die Verbindungen zugesteuert und damit die Bitleitungen, also auch die Bitleitungskapazitäten, abgetrennt. Die angelatchten Sensorflipflops können nun ohne den verzögernden Einfluß der Bitleitungskapazitäten schnell gelatcht werden, wobei die Bitleitungen nicht weiter entladen werden. Damit verringert sich die Zugriffszeit.

Vorteilhafte Ausgestaltungen der erfindungsgemäßen Lösung ergeben sich aus den Ansprüchen 2 bis 10.

Dabei werden die Auswahltransistoren in den Bitleitungen, die Fußpunkttransistoren der Sensorflipflops und die steuerbaren Verbindungen von einem einzigen Taktsignal angesteuert, wobei für die steuerbaren Verbindungen noch die erforderliche Verknüpfung mit dem im Speicher geführten Schreibsignal vorgenommen wird.

Erfindungsgemäß wird die genannte Aufgabe ebenfalls durch eine Schreib-Lese-Schaltung für einen statischen RAM mit den Merkmalen des Patentanspruches 11 gelöst.

Bei nichtaktivem Latchtakt sind die steuerbaren Verbindungen in den Datenleitungspaaren leitfähig, so daß die Datenleitungen mit den Eingängen der zugehörigen Leseverstärker verbunden sind.

Mit einer in den Zeitgliedern eingestellten, den internen Zeitabläufen des Speichers entsprechenden Zeitverzögerung zum Anlatchen der Bitleitungen an die Sensorflipflops werden - da sich die Knoten der Leseverstärker aufgrund des Verhältnisses der Kapazitäten der Datenleitungen zu der des zugehörigen Leseverstärkers schnell aufladen - mit steigendem Potential der Datenlatchtakte die steuerbaren Verbindungen zugesteuert, wodurch die Datenleitungen von den Leseverstärkern abgetrennt werden. Damit werden auch die Datenleitungen nicht weiter, also nur teilweise entladen, so daß kein langes Vorladen erforderlich wird.

Vorteilhafte Ausgestaltungen hierzu sind in den Ansprüchen 12 bis 15 dargelegt.

Auch hierbei kommt zur Ansteuerung der steuerbaren Verbindungen und der Fußpunkttransistoren der Leseverstärker nur jeweils ein Taktsignal, der aus der Verzögerung des Latchtaktes generierte Datenlatchtakt, zur Anwendung.

Als besonders günstig erscheint eine Schaltungsanordnung mit den Merkmalen der Patentansprüche 1 und 11, bzw. in ihren Ausgestaltungen nach den Patentansprüchen 2 bis 10 und 12 bis 15, welche die vorteilhaften Wirkungen beider Lösungen vereinigt.

Die Erfindung sei nunmehr in einem Ausführungsbeispiel anhand von sechs Zeichnungen näher erläutert.

Dabei zeigen:

Fig. 1　die erfindungsgemäße Schaltungsanordnung

Fig. 2a...2e　je eine Ausführung einer steuerbaren Verbindung.

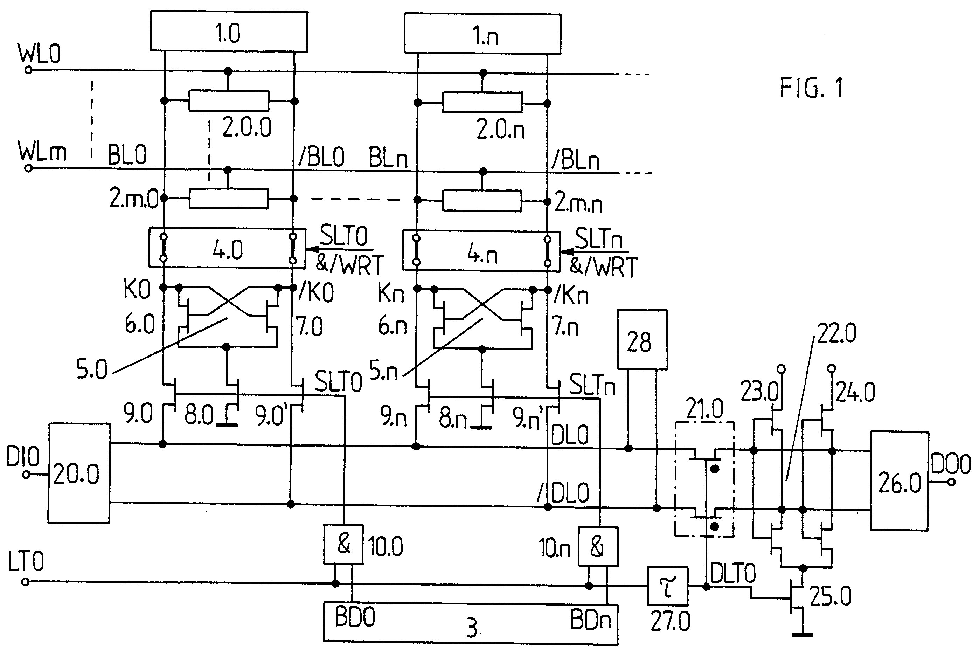

Wie in Fig. 1 dargestellt, enthält der statische RAM mit der erfindungsgemäßen Schreib-Lese-Schaltung n an Bitleitungsvorladeschaltungen 1.i (mit i = 0...n) angeschlossene Bitleitungspaare BLi; /BLi und m Wortleitungen WL0...WLm, zwischen denen m*n Speicherzellen 2.0.0...2.m.n angeordnet sind. Die Bitleitungspaare BLi; /BLi sind jeweils über eine in ihrer Leitfähigkeit steuerbare Verbindung 4.i mit den Knoten Ki; /Ki von Sensorflipflops 5.i verbunden. Jedes Sensorflipflop 5.i ist aus zwei kreuzgekoppelten Transistoren 6.i; 7.i, deren Fußpunkt jeweils über einen Fußpunkttransistor 8.i auf Masse geführt ist, aufgebaut. Im weiteren sind die Knoten Ki; /Ki der Sensorflipflops 5.i über je einen Auswahltransistor 9.i bzw. 9.i' mit einem Datenleitungspaar DL0; /DL0 des RAM verbunden. Für jedes Bitleitungspaar BLi;/BLi sind die Gates der Auswahltransistoren 9.i; 9.i' untereinander sowie mit dem Gate des Fußpunkttransistors 8.i verbunden und werden von einem zugehörigen Sensorlatchtakt SLTi angesteuert. Zur Generierung der Sensorlatchtakte SLTi ist ein im RAM geführter, dem Datenleitungspaar DL0; /DL0 zugeordneter Latchtakt LT0 jeweils über ein AND-Gatter 10.i mit einem dem Bitleitungspaar BLi; /BLi zugeordneten Ausgang BDi eines Spaltendekoders 3 verknüpft.

Auf die steuerbare Verbindung 4-i in jedem Bitleitungspaar BLi; /BLi ist der zugehörige Sensorlatchtakt SLTi, konjunktiv mit einem globalen low-aktiven Schreibsignal /WRT des RAM verknüpft, gelegt.

Das Datenleitungspaar DL0; /DL0 ist an einer Dateneingangsschaltung 20.0, deren Eingang einen Dateneingang DI0 des RAM darstellt, und weiterhin an einer Datenleitungsvorladeschaltung 28 angeschlossen.

Das Datenleitungspaar DL0; /DL0 ist nun über eine in ihrer Leitfähigkeit steuerbare Verbindung 21.0, welche im einfachsten Fall aus einem Transistor - wie dargestellt aus einem pMOS-Transistor - je Datenleitung DL0 bzw. /DL0 realisiert ist, auf einen Leseverstärker 22.0 geführt. Dieser ist aus zwei kreuzgekoppelten Negatoren 23.0; 24.0 mit gemeinsamem Fußpunkt, der über einen gesteuerten Fußpunkttransistor 25.0 mit Masse verbunden ist, aufgebaut. Die Ausgänge des Leseverstärkers 22.0 sind auf eine Datenausgangsschaltung 26.0 gelegt, deren Ausgang einen Datenausgang DO0 des RAM realisiert.

Dabei sind die Gates der Transistoren der steuerbaren Verbindung 21.0 und des Fußpunkttransistors 25.0 von einem Datenlatchtakt DLT0 angesteuert, welcher aus dem über ein Zeitglied 27.0 geführten Latchtakt LT0 abgeleitet ist. Das Zeitglied kann - nicht dargestellt - im einfachsten Fall aus zwei in Reihe geschalteten Negatoren konfiguriert sein.

Die beim Lesen (low-aktives Schreibsignal /WRT führt High-Potential) steuerbare Verbindung 4.i im vom Ausgang BDi des Spaltendekoders 3 angesteuerten Bitleitungspaar BLi; /BLi ist zu Beginn jedes Latchtaktes LT0 leitfähig und verliert die Leitfähigkeit in dem Maße, wie die Flanke des Latchtaktes LT0 High-Potential annimmt. Damit liegen zu Beginn des Latchens die Kapazitäten der Bitleitungen BLi; /BLi voll an den Knoten Ki; /Ki des Sensorflipflops 5.i an und unterstützen das Anlatchen, da durch sie Unsymmetrien der Layoutgestaltung und andere Störeinflüsse gepuffert werden.

Mit steigendem Potential des Latchtaktes LT0 wird die steuerbare Verbindung 4.i zugesteuert, wodurch die Bitleitungskapazitäten von den Knoten Ki; /Ki des Sensorflipflops 5.i abgeschaltet werden. Das angelatchte Sensorflipflop 5.i kann nun ohne den bremsenden Einfluß der Bitleitungskapazitäten schnell gelatcht werden, wobei die Bitleitungen BLi; /BLi nicht weiter - d. h. also nur teilweise - entladen werden, so daß je Zyklus kein langes Vorladen notwendig wird und sich damit die Zugriffszeit verringert.

Bei nichtaktivem Latchtakt LTØ ist auch die steuerbare Verbindung 21.Ø im Datenleitungspaar DLØ; /DLØ leitfähig, so daß die Datenleitungen DLØ bzw. /DLØ mit den Eingängen des Leseverstärkers 22.Ø verbunden sind.

Mit einer im Zeitglied 27.Ø eingestellten, den internen Zeitabläufen des Speichers entsprechenden Zeitverzögerung zum Anlatchen der Bitleitungen BLi; /BLi an die Sensorflipflops 5.i wird - da sich die Knoten des Leseverstärkers 22.Ø aufgrund des Verhältnisses der Kapazitäten der Datenleitungen DLØ; /DLØ zu der des Leseverstärkers 22.Ø schnell aufladen - mit steigendem Potential des Datenlatchtaktes DLTØ die steuerbare Verbindung 21.Ø zugesteuert, wodurch die Datenleitungen DLØ; /DLØ vom Leseverstärker 22.Ø abgetrennt werden. Damit werden auch die Datenleitungen DLØ; /DLØ nicht weiter, also nur teilweise entladen, so daß kein langes Vorladen erforderlich wird.

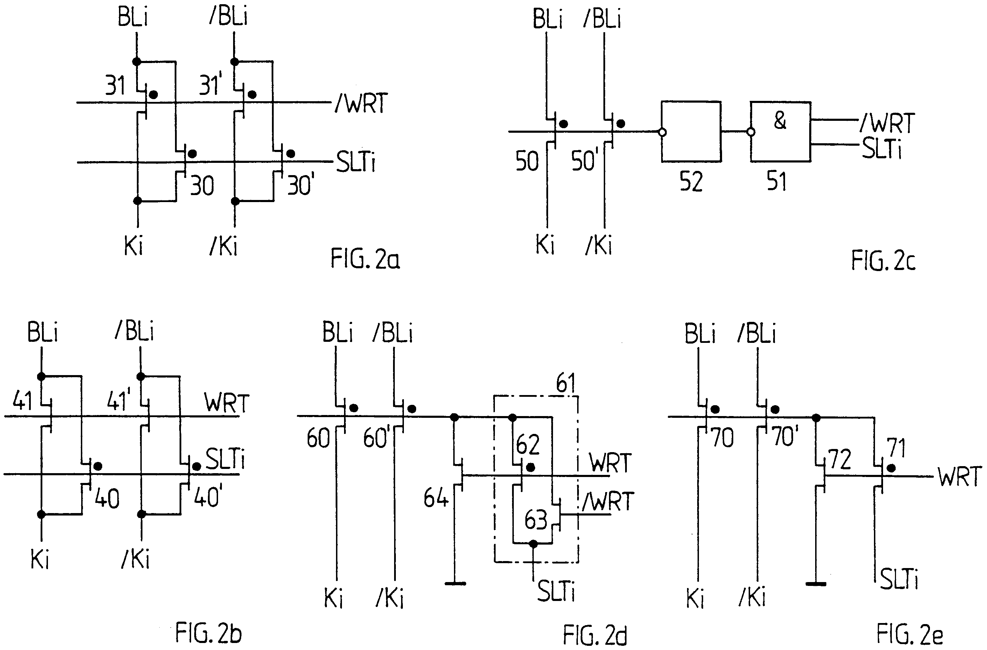

In den Fig. 2a...2e sind nun einzelne Ausführungsmöglichkeiten der steuerbaren Verbindungen 4.i gezeigt.

Nach Fig. 2a besteht die steuerbare Verbindung 4.i je Bitleitung BLi bzw. /BLi aus zwei parallel geschalteten pMOS-Transistoren 3Ø; 31 bzw. 3Ø'; 31'. Dabei liegt am Gate des jeweils ersten Transistors 3Ø bzw. 3Ø' der dem Bitleitungspaar BLi; /BLi zugehörige Sensorlatchtakt SLTi und am Gate des jeweils zweiten Transistors 31 bzw. 31' das low-aktive Schreibsignal /WRT an. Über letzteres wird die beim Beschreiben des RAM konstant leitfähige Verbindung realisiert.

In Analogie hierzu sind nach Fig. 2b jeweils ein pMOS-Transistor 4Ø bzw. 4Ø' und ein nMOS-Transistor 41 bzw. 41' parallel geschaltet, wobei die Transistoren 41 bzw. 41' dann vom high-aktiven Schreibsignal WRT angesteuert werden.

In der Ausführung gemäß Fig. 2c ist die steuerbare Verbindung 4.i durch einen pMOS-Transistor 5Ø bzw. 5Ø' realisiert, auf dessen Gate der in einem NAND-Gatter 51 mit nachgeschaltetem Negator 52 mit dem low-aktiven Schreibsignal /WRT verknüpfte Sensorlatchtakt SLTi gelegt ist.

Vorteilhaft ist hier, daß nur ein Transistor benötigt wird, allerdings ergeben sich nachteilige Verzögerungen in den Logikgattern.

Nach Fig. 2d besteht die steuerbare Verbindung 4.i ebenfalls nur aus einen pMOS-Transistor 6Ø bzw. 6Ø'. Die Gates der Transistoren 6Ø bzw. 6Ø' sind über ein Transfergate 61, welches aus einem pMOS-Transistor 62 mit parallel geschaltetem nMOS-Transistor 63 aufgebaut ist, am Sensorlatchtakt SLTi angeschlossen. An das Gate des Transistors 62 ist der highaktive Schreibtakt WFT und an das Gate des Transistors 63 der low-aktive Schreibtakt /WPT gelegt. Zwischen dem Gate des Transistors 6Ø bzw. 6Ø' und Masse ist ein nMOS-Entladetransistor 64 geschaltet, der vom Schreibtakt WRT angesteuert wird. Der Entladetransistor 64 verhindert ein Floaten der Gates der Transistoren 6Ø bzw. 6Ø'.

Die Schaltung nutzt die geringe Verzögerungszeit eines Transfergates aus.

In Fig. 2e wird zur Ansteuerung der pMOS-Transistoren 7Ø bzw. 7Ø' in den Bitleitungen BLi; /BLi anstelle des Tranfergates 61 der Fig. 2d nur ein pMOS-Transistor 71 eingesetzt, so daß nur der high-aktive Schreibtakt WRT zur Ansteuerung benötigt wird. Dies ist bei Platzproblemen oft günstiger als die hier nicht gegebene volle Übertragung des Low-Pegels beim Schreiben der Information in die Speicherzelle. Der nMOS-Entladetransistor 72 ist beibehalten.

In weiterer Ausgestaltung der Schaltungsanordnung erscheinen Ausführungen mit Adressverriegelungen in den Sensorflipflops 5.i; mit mehreren Bitleitungspaaren BLi; /BLi je Sensorflipflop 5.i bzw. mit Datenweichen und mehreren Datenleitungspaaren DLk; /DLk je Leseverstärker 22.k.

**Patentansprüche**

1. Schreib-Lese-Schaltung für einen statischen RAM mit n Bitleitungspaaren und m Wortleitungen, zwischen denen Speicherzellen angeordnet sind, wobei die Bitleitungspaare jeweils mit den Knoten von Sensorflipflops verbunden sind, deren Fußpunkttransistoren von einem zugehörigen Latchtakt gesteuert sind, wobei die Knoten der Sensorflipflops über Auswahltransistoren mit Datenleitungspaaren des RAM verbunden und wobei die Auswahltransistoren von den einzelnen Bitleitungspaaren zugeordneten Ausgängen eines Spaltendekoders angesteuert sind, dadurch gekennzeichnet, daß jeweils zwischen wahrer (BLi) bzw. negierter Bitleitung (/BLi) jedes Bitleitungspaares (BLi; /BLi) und wahrem (Ki) bzw. negiertem Knoten (/Ki) des zugehörigen Sensorflipflops (5.i) eine in ihrer Leitfähigkeit steuerbare Verbindung (4.i), welche beim Beschreiben des RAM durchgängig sowie beim Lesen zu Beginn des zugehörigen Latchtaktes (LTk) leitfähig ist und ihre Leitfähigkeit in dem Maße verliert, wie das Potential des Latchtaktes (LTk) steigt, angeordnet ist.

2. Schreib-Lese-Schaltung nach Anspruch 1, dadurch gekennzeichnet, daß jede steuerbare Verbindung (4.i) von einem dem zugehörigen Bitleitungspaar (BLi; /BLi) entsprechenden Sensorlatchtakt (SLTi) , konjunktiv mit einem Schreibsignal (/WRT) des RAM verknüpft, angesteuert ist.

3. Schreib-Lese-Schaltung nach Anspruch 2, dadurch gekennzeichnet, daß jeder Sensorlatchtakt (SLTi) auf die Gates der dem entsprechenden Bitleitungspaar (BLi; /BLi) zugehörigen Auswahltransistoren (9.i; 9.i') gelegt ist.

4. Schreib-Lese-Schaltung nach Anspruch 2 oder 3, dadurch gekennzeichnet, daß jeder Sensorlatchtakt (SLTi) auf das Gate des Fußpunkttransistors (8.i) des, dem entsprechenden Bitleitungspaar (BLi; /BLi) zugehörigen Sensorflipflops (5.i) geführt ist.

5. Schreib-Lese-Schaltung nach einem der Ansprüche 2 bis 4, dadurch gekennzeichnet, daß jeder Sensorlatchtakt (SLTi) aus einem der Latchtakte (LTk), welcher dem angeschlossenen Datenleitungspaar (DLk; /DLk) zugeordnet ist, konjunktiv mit dem dem zugehörigen Bitleitungspaar (BLi; /BLi) entsprechenden Ausgang (BDi) des Spaltendekoders (3) verknüpft, generiert ist.

6. Schreib-Lese-Schaltung nach einem der Ansprüche 1 bis 5, dadurch gekennzeichnet, daß die steuerbaren Verbindungen (4.i) je Bitleitung (BLi bzw. /BLi) durch zwei parallel geschaltete pMOS-Transistoren (3Ø; 31) realisiert sind, wobei an das Gate des ersten Transistors (3Ø) der zugehörige Sensorlatchtakt (SLTi) und an das Gate des zweiten Transistors (31) das low-aktive Schreibsignal (/WRT) gelegt ist.

7. Schreib-Lese-Schaltung nach einem der Ansprüche 1 bis 5, dadurch gekennzeichnet, daß die steuerbaren Verbindungen (4.i) je Bitleitung (BLi bzw. /BLi) durch einen pMOS-Transistor (40) mit parallel geschaltetem nMOS-Transistor (41) realisiert sind, wobei an das Gate des pMOS-Transistors (4Ø) der zugehörige Sensorlatchtakt (SLTi) und an das Gate des nMOS-Transistors (41) das high-aktive Schreibsignal (WRT) gelegt ist.

8. Schreib-Lese-Schaltung nach einem der Ansprüche 1 bis 5, dadurch gekennzeichnet, daß die steuerbaren Verbindungen (4.i) je Bitleitung (BLi bzw. /BLi) durch einen pMOS-Transistor (5Ø) realisiert sind, auf dessen Gate der zugehörige Sensorlatchtakt (SLTi), konjunktiv mit dem low-aktiven Schreibsignal (/WRT) verknüpft, geführt ist.

9. Schreib-Lese-Schaltung nach einem der Ansprüche 1 bis 5, dadurch gekennzeichnet, daß die steuerbaren Verbindungen (4.i) je Bitleitung (BLi bzw. /BLi) durch einen pMOS-Transistor (60) realisiert sind, an dessen Gate über ein Transfergate (61) der zugehörigen Sensorlatchtakt (SLTi) angeschlossen ist, wobei das Transfergate (61) von low-aktiven Schreibsignal (/WRT) und vom high-aktiven Schreibsignal (WRT) angesteuert ist, und daß zwischen dem Gate des Transistors (6Ø) und Massepotential ein vom high-aktiven Schreibsignal (WRT) gesteuerter nMOS-Entladetransistor (64) angeordnet ist.

10. Schreib-Lese-Schaltung nach einem der Ansprüche 1 bis 5, dadurch gekennzeichnet, daß die steuerbaren Verbindungen (4.i) je Bitleitung (BLi bzw. /BLi) durch einen pMOS-Transistor (60) realisiert sind, dessen Gate über einen vom high-aktiven Schreibsignal (WRT) gesteuerten pMOS-Transistor (62) am zugehörigen Sensorlatchtakt (SLTi) angeschlossen und daß zwischen dem Gate des Transistors (6Ø) und Massepotential ein ebenfalls vom high-aktiven Schreibsignal (WRT) gesteuerter nMOS-Entladetransistor (64) angeordnet ist.

11. Schreib-Lese-Schaltung für einen statischen RAM mit n Bitleitungspaaren und m Wortleitungen, zwischen denen Speicherzellen angeordnet sind, wobei die Bitleitungspaare jeweils mit den Knoten von Sensorflipflops sowie diese Knoten wiederum über von zugehörigen Ausgängen eines Spaltendekoders angesteuerte Auswahltransistoren mit Datenleitungspaaren verbunden sind und wobei die Datenleitungspaare über Dateneingangsschaltungen an Dateneingängen des RAM angeschlossen sowie über Leseverstärker auf Datenausgangsschaltungen geführt sind, deren Ausgänge Datenausgänge des RAM realisieren, dadurch gekennzeichnet, daß jeweils zwischen wahrer (DLk) bzw. negierter Datenleitung (/DLk) jedes Datenleitungspaares (DLk; /DLk) und wahrem bzw. negiertem Eingang des entsprechenden Leseverstärkers (22.k) eine in ihrer Leitfähigkeit steuerbare Verbindung (21.k), welche beim Beschreiben sowie beim Lesen des RAM zu Beginn des zugehörigen Latchtaktes (LTk) leitfähig ist und ihre Leitfähigkeit mit einer vorab festgelegten Zeitverzögerung in dem Maße verliert, wie das Potential des Latchtaktes (LTk) steigt, angeordnet ist.

12. Schreib-Lese-Schaltung nach Anspruch 11, dadurch gekennzeichnet, daß jede der steuerbaren Verbindungen (21.k) von einem zugehörigen Datenlatchtakt (DLTk) gesteuert ist.

13. Schreib-Lese-Schaltung nach Anspruch 12, dadurch gekennzeichnet, daß jeder Datenlatchtakt (DLTk) aus dem über ein Zeitglied (27.k) geführten zugehörigen Latchtakt (LTk) generiert ist.

14. Schreib-Lese-Schaltung nach einem der Ansprüche 11 bis 13, dadurch gekennzeichnet, daß jeder Leseverstärker (22.k) aus zwei kreuzgekoppelten Negatoren (23.k; 24.k) mit steuerbarem Fußpunkttransistor (25.k) aufgebaut ist.

15. Schreib-Lese-Schaltung nach Anspruch 14, dadurch gekennzeichnet, daß an das Gate jedes Fußpunkttransistors (25.k) der zugehörige Datenlatchtakt (DLTk) gelegt ist.

FIG. 1

FIG.2a

FIG.2b

FIG.2c

FIG.2d

FIG.2e